# EUROPEAN PATENT APPLICATION

(11) **EP 2 192 159 A2**
(43) Date of publication of application: **02.06.2010**
(21) Application number: 09252682.1
(22) Date of filing: 26.11.2009
(51) Int. Cl.: C09B 21/00, C09B 57/00, C09B 23/04, H01L 51/00

(54) **Dye compound for dye-sensitized solar cells, dye-sensitized photoelectric converter and dye-sensitized solar cells**

(30) Priority: 28.11.2008 KR 20080119746; 28.09.2009 KR 20090091854
(71) Applicant: Samsung Electro-Mechanics Co., Ltd, Suwon Gyunggi-do 443-743 (KR)
(72) Inventor: Park, Sung-Soo, Gyeonggi-do, 446-773 (KR); Kim, Jae-Hong, Daegu, 706-040 (KR); Choi, Chang-Hwan, Gyeonggi-do, 463-727 (KR); An, Ji-Chul, Gyeonggi-do, 410-360 (KR); Ji, Soo-Young, Gyeonggi-do, 443-753 (KR); Won, Yong-Sun, Seoul, 156-857 (KR); Kim, Hyun-Jun, Gyeonggi-do, 442-725 (KR)
(74) Representative: Fairbairn, Angus Chisholm

(57) **Abstract**

A dye compound for solar cells, a dye-sensitized photoelectric converter and dye-sensitized solar cells are provided. The photoelectric conversion efficiency of solar cells is improved by using the dye compound: 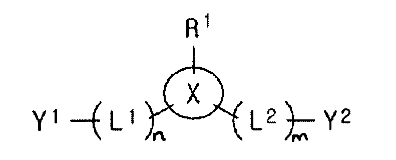 of which X is at least one aromatic group and symmetric about the X-R¹ bond axis or at least hetero aromatic group having at least one hetero atom chosen from N and S and symmetric about the X-R¹ bond axis; R¹is substituted or unsubstituted C1 to C20 cyclic alkyl or substituted or unsubstituted C1 to C20 linear alkyl; L¹ and L² are substituted or unsubstituted hydrocarbons having 2 to 8 conjugated p-orbitals; Y¹ and Y² are better electron-withdrawing groups than X and may contain at least one acidic hydrogen which is able to form a hydrogen bond.

## Description

This application claims the benefit of Korean Patent Application Nos. 10-2008-0119746 and 10-2009-0091854, the contents of which are incorporated here by reference in their entirety.

### BACKGROUND

### 1. Technical Field

This invention relates to a dye compound for solar cells, a dye-sensitized photoelectric converter and dye-sensitized solar cells which may increase photoelectric conversion efficiency.

### 2. Description of the Related Art

Fossil energy is the energy we use at the present time like petroleum, coal and natural gases. However fossil fuels will run out one day since there is a limited amount thereof available and they release environmentally harmful compounds so there is a need to look for alternative sources of energy to replace them.

Energy sources to replace fossil fuels are tidal power which can be obtained from the changing tide levels, wind power, the geothermal energy, solar energy and the like.

Such alternative sources of energy are already in use like for heating and generation of electric power.

Solar cells, which use silicon as a light absorption layer, are classified into crystalline solar cells and thin layer (crystalloid, amorphous) solar cells as silicon solar cells and examples of compound semiconductor solar cells include Group II-VI thin layer solar cells such as cadmium telluride (CdTe) or copper indium selenide (CIS, CuInSe₂), Group III-V solar cells and the like. Unlike other semiconductor junction solar cells, a dye-sensitized solar cell, which is a high energy efficient photoelectrochemical solar cell based on the principle of photosysthesis, has been disclosed by the Gratzel group in Switzerland in 1991.

Many businesses and academics show remarkable interest in the dye-sensitized solar cell since it provides high energy conversion efficiency comparable to amorphous silicon solar cells and cost efficiency.

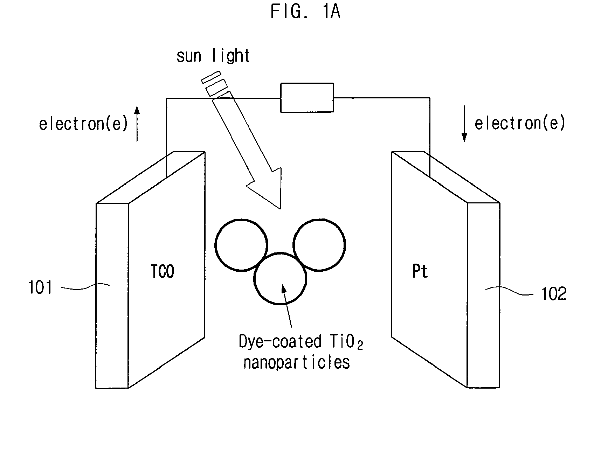

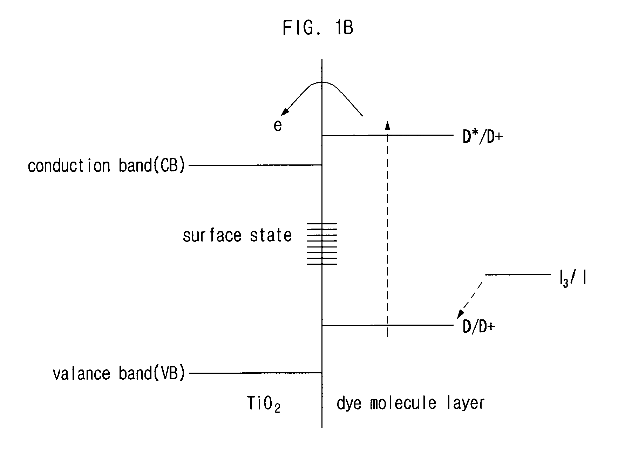

Figs. 1A and 1B illustrate respectively structural and operation conceptual diagrams of a conventional dye-sensitized solar cell.

As shown in Fig. 1A, the dye-sensitized solar cell includes a first electrode 101 and a second electrode 102 which are facing each other, in which the first electrode 101 is a visible ray transparent conducting oxide (TCO) electrode and the second electrode 102 is facing against light and composed of a metal electrode having high reflectivity. Dye-coated semiconductor oxide nanoparticles such as TiO₂ in an electrolyte are between the first electrode and the second electrode.

As shown in Fig. 1B illustrating the operation conceptual diagram of the dye-sensitized solar cell, when dye molecules which are adsorbed chemically on the surface of n-type semiconductor oxide nanoparticles and absorb visible rays, they produce electron-hole pairs of which electrons are injected into a conduction band (CB) of the semiconductor oxide. The electrons injected into the semiconductor oxide electrode are transferred to a transparent conducting oxide electrode, which is the first electrode, through an interface of nanoparticles and generate current. The holes produced on the dye molecules receive electrons from the oxidation/reduction electrolyte and are reduced again.

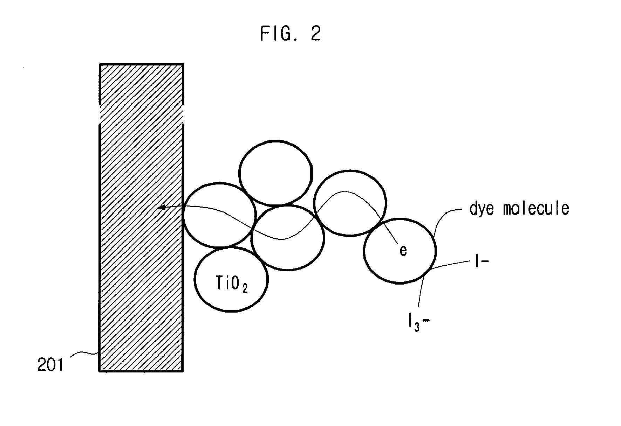

Fig. 2 is a schematized conceptual diagram illustrating pathways of photoelectrons, produced by dye molecules, in a dye-sensitized solar cell.

As shown in Fig. 2, the photoelectrons, produced by dye molecules, are injected to a nanoparticle semiconductor, diffused through a semiconductor interface and collected in the first electrode, which is the transparent conducting oxide electrode.

Both the first electrode and the second electrode, facing to the first electrode of dye-sensitized solar cells, are transparent electrodes but the second electrode is generally coated with platinum (Pt) having good reflectivity to improve energy efficiency.

However, such dye molecules are not able to transfer photoelectrons efficiently enough to the electrode which thus deteriorates the efficiency of solar cells. Thus, there is a strong need to develop novel dye compounds having high photoelectric conversion efficiency.

The present invention provides a dye compound for solar cells which is able to improve photoelectric conversion efficiency of dye-sensitized photoelectric converters and dye-sensitized solar cells.

According to an aspect of the invention, there is provided a dye compound for solar cells, represented by the following formula 1: 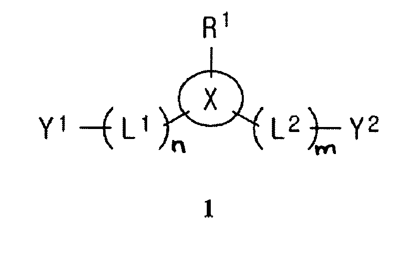 wherein X is at least one aromatic group and symmetric about the X-R¹ bond axis or at least one hetero aromatic group having at least one hetero atom chosen from O, N and S and symmetric about the X-R¹ bond axis; R¹is substituted or unsubstituted C1 to C20 cyclic alkyl or substituted or unsubstituted C1 to C20 linear alkyl; L¹ and L² are substituted or unsubstituted secondary hydrocarbons having at least 2 of conjugated p-orbitals; n and m is an integer of 0 to 8; and Y¹ and Y² are better electron-withdrawing group than X and may contain at least one acidic hydrogen which is able to form a hydrogen bond.

According to an embodiment, X may be represented by formula 2a or formula 2b.

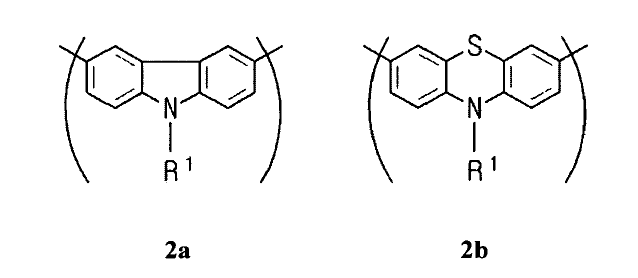

According to an embodiment, the Y¹ and Y² may be one independently chosen from formula 3a, formula 3b, formula 3c and formula 3d.

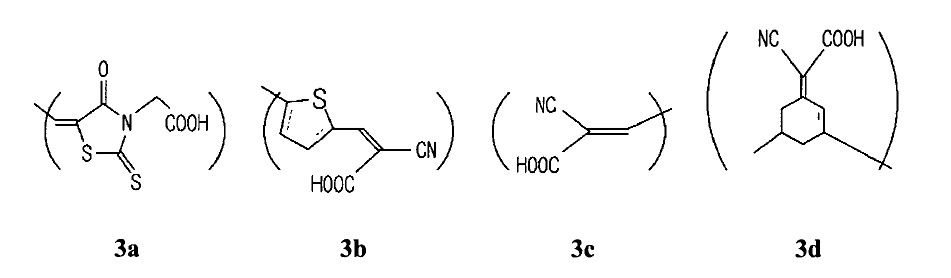

According to an embodiment, the L¹ and L² may be the same or different groups independently chosen from formula 4a, formula 4b and formula 4c, with n and m each representing an integer from 1 to 4: 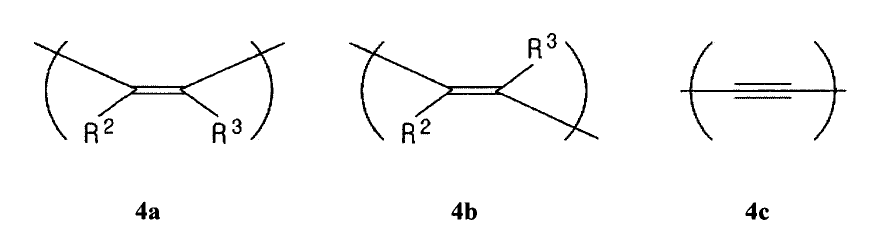 wherein in the formula 4a and formula 4b, R² and R³ may be independently hydrogen or substituted or unsubstituted C 1 to C4 alkyl.

According to an embodiment, X may be chosen from formula 2a and formula 2b, Y¹ and Y² may be independently chosen from formula 3a, formula 3b, formula 3c and formula 3d, and the L¹ and L² may be the same or different groups independently chosen from formula 4a, formula 4b and formula 4c with n and m each representing an integer from 1 to 4.

In another embodiment of the invention, there is provided a dye compound for solar cells represented by the following formula 5.

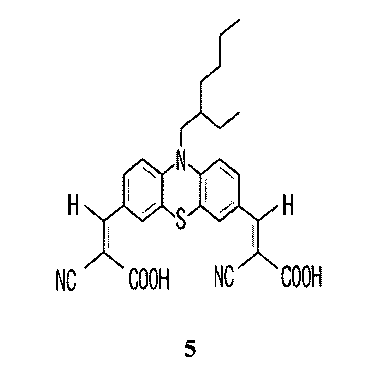

In further another embodiment, there is provided a dye compound for solar cells represented by the following formula 6.

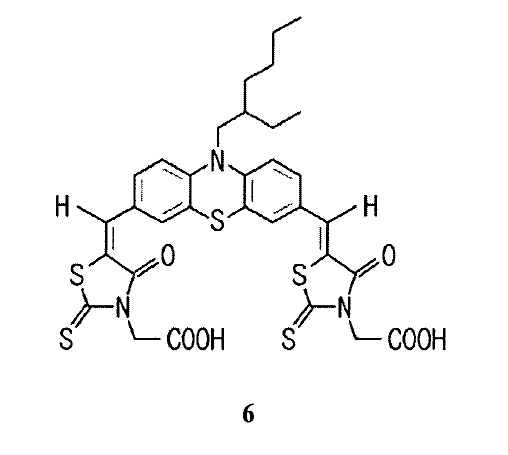

In further another aspect of the invention, there is provided a dye-sensitized photoelectric converter including semiconductor oxide particles supporting the dye compound for solar cells.

In further another aspect of embodiments, there is provided dye-sensitized solar cells including the dye-sensitized photoelectric converter.

### BRIEF DESCRIPTION OF THE DRAWINGS

Fig. 1A is structure of a dye-sensitized solar cell according to an embodiment of a conventional technology.
Fig. 1B is an operation conceptual diagram of a dye-sensitized solar cell according to an embodiment of a conventional technology.
Fig. 2 is a schematized conceptual diagram illustrating photoelectron pathways of a dye-sensitized solar cell according to an embodiment of a conventional technology.
Fig. 3A shows experimental data of a Comparison Example.
Fig. 3B shows experimental data of an Example.
Fig. 4 shows absorbance of a compound according to an embodiment of the invention.

While the present invention has been described with reference to particular embodiments, it is to be appreciated that various changes and modifications may be made by those skilled in the art without departing from the scope of the present invention. Throughout the description of the present invention, when describing a certain technology is determined to evade the point of the present invention, the pertinent detailed description will be omitted.

Hereinafter, preferred embodiments will be described in detail of the dye compound for solar cells, the dye-sensitized photoelectric converter and dye-sensitized solar cells according to the present invention.

### DETAILED DESCRIPTION

According to an embodiment, a dye compound for solar cells may be expressed by the following formula 1: 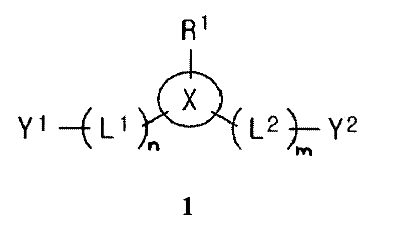 wherein X is at least one aromatic group which is symmetric about the X-R¹ bond axis or at least one hetero aromatic group having at least one hetero atom chosen from N and S and symmetric about the X-R¹ bond axis; R¹ is substituted or unsubstituted C1 to C20 cyclic alkyl or substituted or unsubstituted C1 to C20 linear alkyl; L¹ and L² are substituted or unsubstituted secondary hydrocarbons having at least 2 of conjugated p-orbitals; n and m is an integer of 0 to 8; and Y¹ and Y² are better electron-withdrawing groups than X and may contain at least one acidic hydrogen which is able to form a hydrogen bond.

The X of formula 1 may be at least one aromatic group which is symmetric about the X-R¹ bond axis or at least one hetero aromatic group having at least one hetero atom chosen from N and S and symmetric about the X-R¹ bond axis. Electrons may distribute toward either Y¹ or Y² group due to the symmetric structure about the X-R¹ bond axis. Electrons may also easily move to Y¹ or Y² group since X is an aromatic or heteroaromatic group.

The X may be expressed by the following formula 2a of formula 2b.

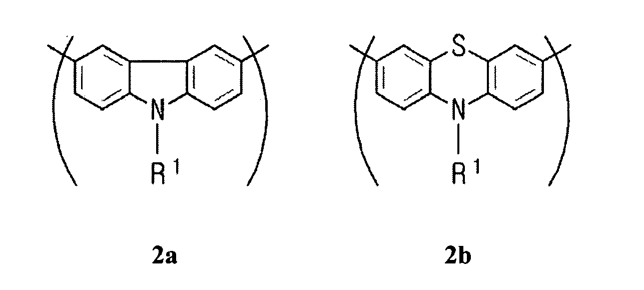

Y¹ and Y² of the formula 1 may be bonded to X through L¹ and L². L¹ and L² may be substituted or unsubstituted secondary hydrocarbons having at least 2 of conjugated p-orbitals. Since the L¹ and L² have conjugated p-orbitals, the electrons may move from X to Y¹ or Y² group. n and m is an integer of 0 to 8 which represents a repeating number of L¹ and L², preferably 0. When the length of the X group becomes longer, it may deteriorate photoelectric conversion efficiency since electron transfer becomes difficult.

L¹ and L² may be the same or different groups independently chosen from formula 4a, formula 4b and formula 4c: 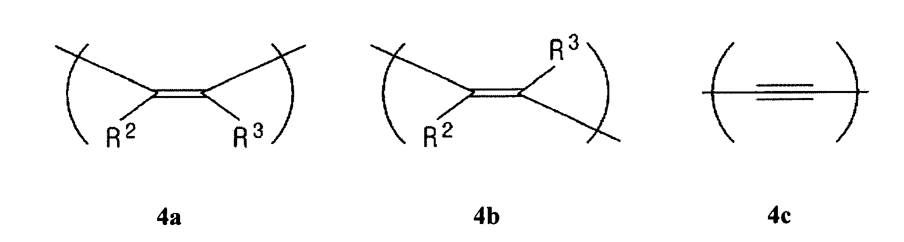 wherein in the formula 4a and formula 4b, R² and R³ may be independently hydrogen or substituted or unsubstituted C1 to C4 alkyl.

For example, L¹ may be a substituted alkene having 6 conjugated p-orbitals by selecting 3 of formula 4a or a substituted alkyne having 4 conjugated p-orbitals by selecting 1 of formula 4c.

The R¹-X group of formula 1 is an electron-donating group, compared to the Y¹ and Y² group which are located at the end of the R¹-X group. Such electron-donating group or electron-withdrawing group is determined relatively.

The electron-withdrawing group may contain at least one of acidic hydrogens which are able to form a hydrogen bond. The hydrogen capable of forming hydrogen bonds may transfer electrons to a transparent conducting oxide electrode which is a first electrode when it bonds to a semiconductor oxide such as TiO₂. A dye compound for solar cells according to an embodiment may include at least two electron-withdrawing groups having acidic hydrogens which are able to transfer electrons to a first electrode so that it may increase the photoelectric conversion efficiency of solar cells.

Y¹ and Y² may be independently chosen from formula 3a, formula 3b, formula 3c and formula 3d.

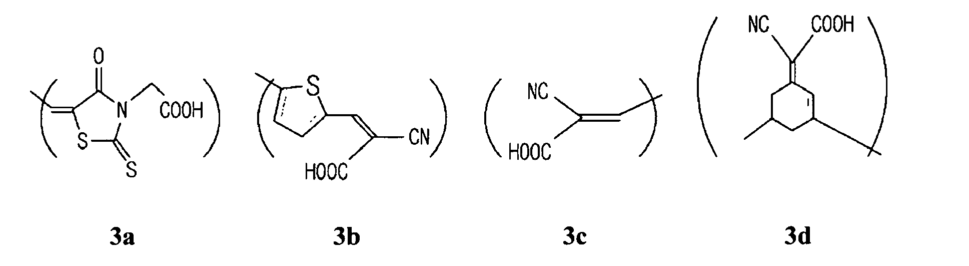

There is provided a dye-sensitized photoelectric converter. In the dye-sensitized photoelectric converter, semiconductor oxide particles may be supported onto the dye compound for solar cells described above. According to an embodiment, the dye-sensitized photoelectric converter may be prepared by using any dye compound, besides the dye compound for solar cells described above. The dye-sensitized photoelectric converter may be prepared by forming a semiconductor oxide thin film on a board by using semiconductor oxide particles and supporting the thin film into a dye.

The board, on which a semiconductor oxide thin film is formed, may have conductivity and be any one commercially available. For example, a conductive metal oxide such as tin oxide coated with indium, fluorine, or antimony or a metal thin film such as steel, silver, gold and the like, formed on the surface of a transparent polymer material such as glass, polyethylenephthalate or polyether sulfone may be used. Here, the conductivity may be 1000 Ω or lower, preferably 100 Ω or lower.

The semiconductor oxide particles may be metal oxides including oxides of titanium, tin, zinc, tungsten, zirconium, gallium, indium, yttrium, niobium, tantalum, vanadium or the like, preferably oxides of titanium, tin, zinc, niobium, or indium, most preferably titanium oxide, zinc oxide or tin oxide and may be used alone or in a combination or coated on the surface of a semiconductor.

A size of the semiconductor oxide particles may be an average particle size of 1-500 nm, preferably 1-100 nm. A larger size and a smaller size of semiconductor oxide particles may be mixed or multi-layered.

The semiconductor oxide thin film may be formed by spraying semiconductor oxide particles directly on a board, electrically reducing a semiconductor particle thin film employing a board as an electrode, or coating paste containing particles which are obtained by the hydrolysis of a semiconductor particle precursor such as a semiconductor particle slurry or alkoxide and then drying, hardening or sintering the result. Here, the slurry may be obtained by dispersing second coagulated semiconductor oxide particles in a dispersion solvent to have an average first particle size of 1-200 nm.

The dispersion solvent may be any solvent which is able to disperse semiconductor particles without any limitation, of which examples may include water, alcohol such as methanol, ketone such as acetone, acetylacetone and the like and hydrocarbons such as hexane and the like, preferably water since it lowers viscosity change of the slurry. This dispersion solvent may be used in combonation. A dispersion stablilizer may be used to stabilize the dispersion state of the semiconductor particles. Example of the dispersion stabilizer may include acid such as acetic acid, hydrochloric acid, nitric acid and the like, acetylacetone, acrylic acid, polyethylene glycol, polyvinyl alcohol and the like.

The board on which the slurry is coated may be sintered at a temperature of 100 °C or higher, preferably 200 °C or higher, of which the upper limit may be lower than the melting temperature (softening temperature) of 900 °C, preferably 600 °C or lower. Sintering time may be about 4 hours but is not be limited thereto.

A thickness of the thin film on a board may be 1-200 µm, preferably 1-50 µm. A part of a thin layer of semiconductor oxide particles may become melted and attached but such melting and attaching does not harm at all here.

The semiconductor oxide thin film may be further treated. For example, the film may be deposited in a solution of alkoxide, oxide, nitride or sulfide of the metal which is the same one as the semiconductor, and dried or resintered to improve its performance. The metal alkoxide may be titanium ethoxide, titanium isopropoxide, titanium t-butoxide, n-dibutyl-diacetyl tin, or the like and an alcohol solution thereof may be used.

The metal oxide may be titanium tetrachloride, tin (tetra)chloride, zinc chloride or the like and its aqueous solution may be used. Such prepared semiconductor oxide thin film may be composed of semiconductor oxide particles.

In order to support the semiconductor oxide particles formed as a thin film on a dye compound, the thin film of semiconductor oxide particles may be immersed into a solution obtained by dissolving a dye compound for solar cells in an appropriate solvent or a dispersion solution obtained by dispersing a dye compound but it is not limited thereto. The concentration of the solution or the dispersion solution may be varied with dye compounds and the supporting temperature may be from room temperature to boiling temperature and the supporting time may be from 1 minute to 48 hours. An example of solvent to dissolve a dye compound may include methanol, ethanol, acetonitrile, dimethylsulfoxide, dimethylformaldehyde, acetone, t-butanol and the like. The concentration of a dye compound in a solution may be 1× 10⁻⁶M to 1M, preferably 1×10⁻⁵M to 1×10⁻¹M. A photoelectric converter containing the thin film of the semiconductor oxide particles, of which performance is improved with a dye compound, may be produced thereby.

One or many dye compounds for solar cells may be used. When more than 1 dye compound is mixed, dye compounds described herein or other dye compounds or metal complex dye compounds may be used. The metal complex dye compound may be ones disclosed in M.K.Nazeeruddin, et al., Chem. Soc., 115, pp 6382(1993) but is not limited thereto. An example of the metal complex dye compound may include ruthenium complex or its quartenary salt, phthalocyanine, porphyrin and the like and an organic dye compound may be metal-free phthalocyanine, porphyrin, cyanine, merocyanine, oxonol, triphenylmethane, and methane dyes such as acrylic acid dye disclosed in W02002/011213, xanthen, azo, anthraquinone, perylene and the like. When more than 2 dye compounds are used, a dye compound may be deposited sequentially or a mixture of dye compounds may be mixed and then deposited on a semiconductor thin film.

When the thin film of semiconductor oxide particles is immersed into a dye compound, it may be immersed into the dye compound in the presence of an inclusion compound in order to prevent binding of the dye compounds to each other. The inclusion compound may be cholic acids such as deoxycholic acid, dehydrodeoxycholic acid, chenodeoxycholic acid, cholic acid methylester, cholic acid sodium salt and the like, steroids such as polyethyleneoxide and the like, crown ether, cyclodextrin, calixarene and the like.

After immersing into a dye compound, the semiconductor electrode surface may be treated with an amine such as 4-*t*-butyl pyridine or a compound having an acidic group such as acetic acid and propionic acid and the like. The treatment may be performed by immersing the semiconductor particle thin film in an amine-ethanol solution.

There is provided dye-sensitized solar cells including the dye-sensitized photoelectric converter. Here the dye-sensitized photoelectric converter, which is prepared by employing semiconductor oxide particles supported on the dye compound of solar cells as described above, or any photoelectric converter may be used. The dye-sensitized solar cell may include a photoelectric converter electrode (cathode) in which the semiconductor oxide particles are supported on a dye compound, a counter electrode (anode), a redox electrolyte, hole transfer material or p-type semiconductor and the like.

Hereinafter, it is described in more detail by the following examples.

While it has been described with reference to particular embodiments, it is to be appreciated that various changes and modifications may be made by those skilled in the art without departing from the scope of the invention.

### Examples 1 and 2. Preparation of dye compounds for solar cells

Dye compounds for solar cells were prepared by the following Scheme 1.

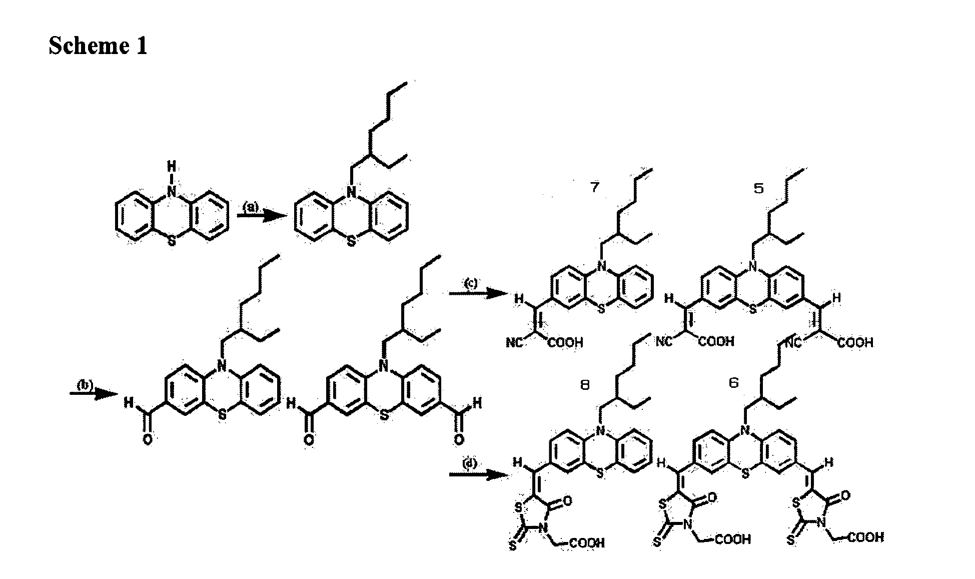

The reaction condition of (a) in Scheme 1 was ethylhexylbromide and NaH in DMF at room temperature, (b) was 1,2-dichloroethane and POCl₃ in DMF at 80°C, (c) was reflux in CH₃CN, cyanoacetic acid and piperidine and (d) was reflux in AcOH, AcONH₄ and rhodanin-3-acetic acid.

Compounds of formula 5, formula 6, formula 7, and formula 8 were prepared by the above method in Scheme 1. The compounds of formula 5 and formula 6 having 2 acidic hydrogens which are electron-withdrawing groups were used as Examples herein and the compounds of formula 7 and formula 8 having 1 acidic hydrogen were used as Comparision Examples.

### <Comparison on Photoelectric Conversion Efficiency >

Dye compounds, expressed by formula 5 to formula 8 which are prepared by following Scheme 1, were determined for their photoelectric conversion efficiencies. The result is shown in Table 1.

**[Table 1]**

| Dye | Extinction Coefficient ε(M⁻¹cm⁻¹) | Short-Circuit Current Density J_{sc}(mA/cm²) | Open Voltage V_{oc}(V) | Fill Factor | Conversion Efficiency (%) |
|---|---|---|---|---|---|
| formula 7 (Com. Ex. 1) | 11134 | 3.905 | 0.625 | 0.620 | 1.556 |
| formula 5 (Ex. 2) | 12604 | 11.005 | 0.725 | 0.724 | 5.643 |
| formula 8 (Com. Ex. 2) | 20752 | 1.574 | 0.425 | 0.635 | 0.431 |
| formula 6 (Ex. 2) | 34723 | 3.942 | 0.525 | 0.628 | 1.251 |

The photoelectric conversion efficiency was determined using a solar simulator under the illumination of 100mW/cm².

The photoelectric conversion efficiency of each dye compound of formula 5 to formula 8 was determined. As shown in Table 1, it is noted that the photoelectric conversion efficiency of the compounds of formula 5 and formula 6 was 3 to 4 times better than that of the compounds of formula 7 and formula 8.

### < Light Absorption of Dye Compounds>

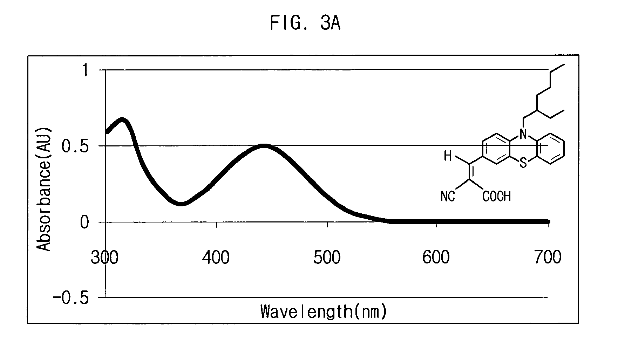

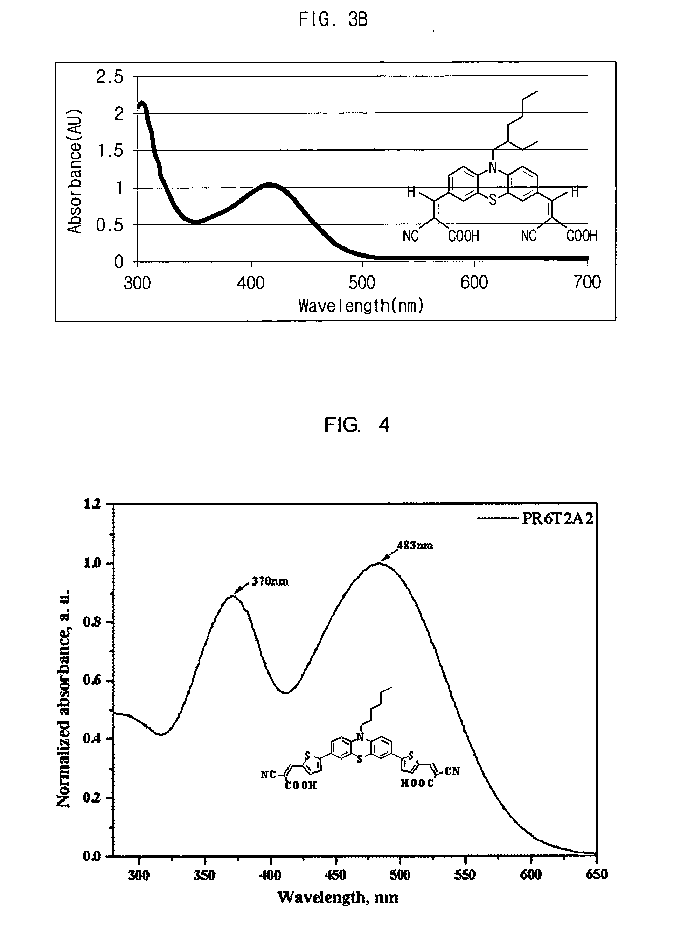

Light absorption graphs according to wavelength for dye compounds were shown in Figs. 3A and 3B. As shown in Fig. 3B, it is noted that the light absorption of the dye compound of formula 5 is 4 times better at a wavelength of about 300nm and twice at a wavelength of about 430nm than that of formula 7. The extinction coefficients in Table 1 were at a wavelength of 430 to 490nm, more particularly, about 460nm for compound 7, about 470nm for compound 5, 475nm for compound 8 and about 485nm for compound 6.

Further, Fig. 4 is a graph illustrating the absorbance of compound 9 prepared as another embodiment of the invention. It is noted that absorbance efficiency is excellent and the absorbances at the wavelength of 370nm and 483nm are similar to those in Example 1 and Example 2.

## Claims

1. A dye compound for solar cells expressed by formula 1: 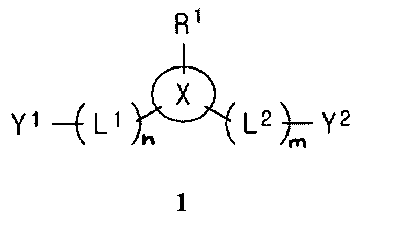 wherein X is at least one aromatic group and symmetric about the X-R¹ bond axis or at least one hetero aromatic group having at least one hetero atom selected from the group consisting of N and S and symmetric about the X-R¹ bond axis; R¹is substituted or unsubstituted C1 to C20 cyclic alkyl or substituted or unsubstituted C1 to C20 linear alkyl; L¹ and L² are substituted or unsubstituted secondary hydrocarbons having at least 2 of conjugated p-orbitals; n and m is an integer of 0 to 8; and Y¹ and Y² are better electron-withdrawing group than X and may contain at least one acidic hydrogen which is able to form a hydrogen bond.

2. The dye compound for solar cells of Claim 1, wherein the X is a compound expressed by formula 2a or formula 2b.

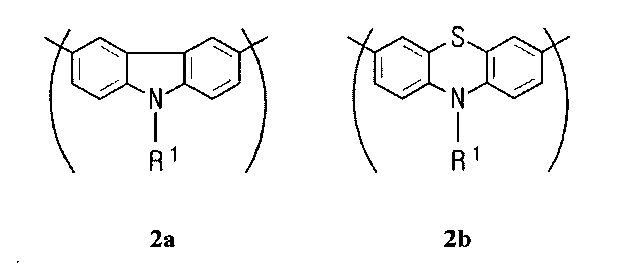

3. The dye compound for solar cells of Claim 1, wherein the Y¹ and Y² is one independently selected from the group consisting of formula 3a, formula 3b, formula 3c and formula 3d.

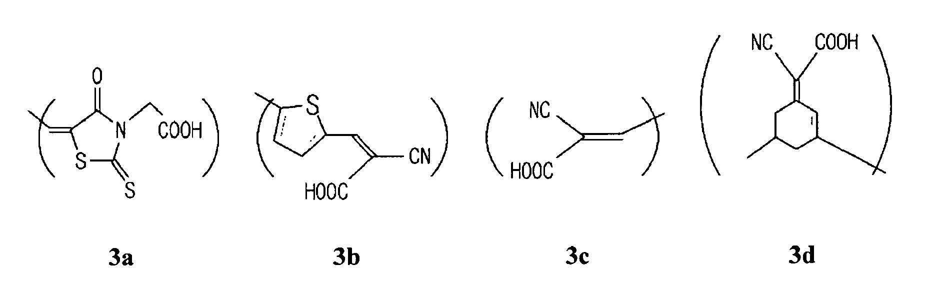

4. The dye compound for solar cells of Claim 1, wherein the L¹ and L² are the same or different groups independently selected from the group consisting of formula 4a, formula 4b and formula 4c: 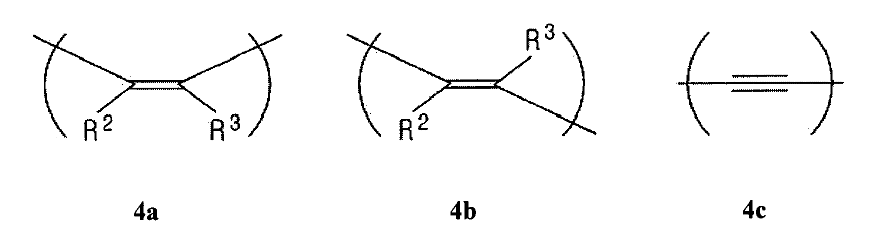 wherein in the formula 4a and formula 4b, R² and R³ are independently hydrogen or substituted or unsubstituted C 1 to C4 alkyl.

5. The dye compound for solar cells of Claim 1, wherein the X is a compound of formula 2a or formula 2b: 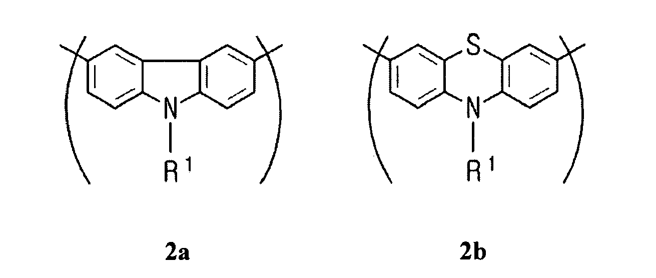 Y¹ and Y² are one independently selected from the group consisting of formula 3a, formula 3b, formula 3c and formula 3d: 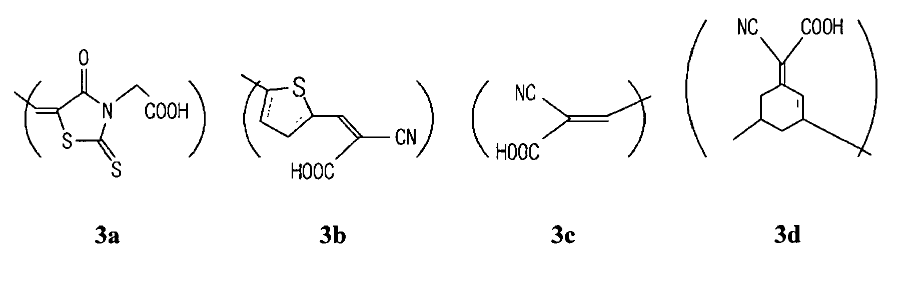 L¹ and L² are the same or different groups independently selected from the group consisting of formula 4a, formula 4b and formula 4c: 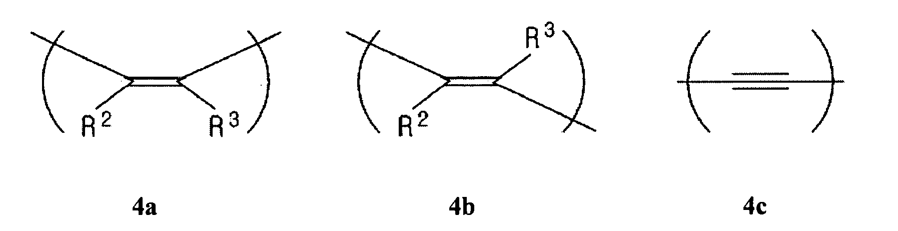 wherein in the formula 4a and formula 4b, R² and R³ are independently hydrogen or C1 to C4 substituted or unsubstituted alkyl,
and n and m are an integer from 1 to 4.

6. A dye compound for solar cells expressed by formula 5:

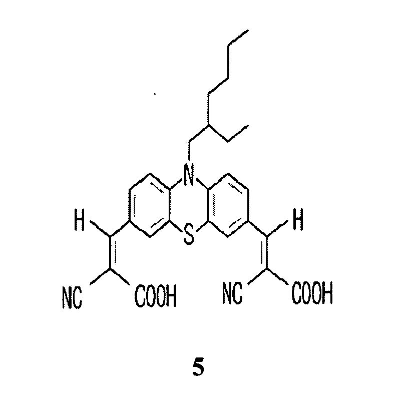

7. A dye compound for solar cells expressed by formula 6:

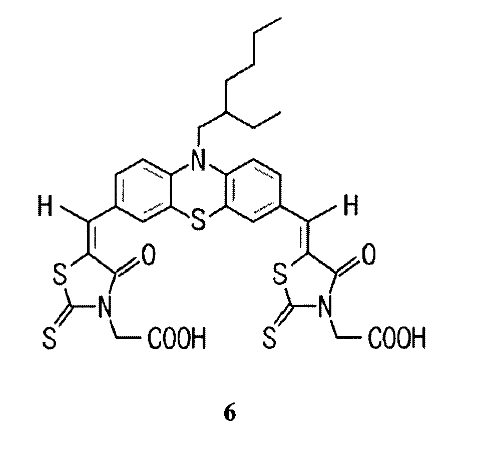

8. A dye compound for solar cells expressed by formula 9:

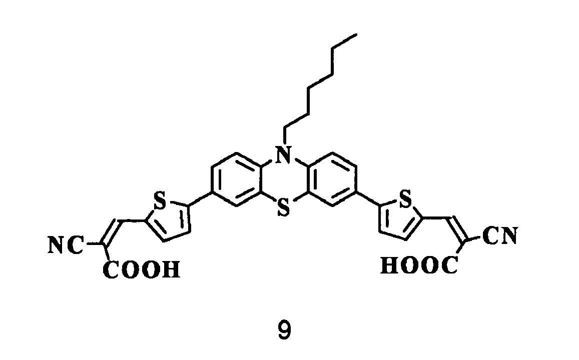

9. A dye-sensitized photoelectric converter comprising semiconductor oxide particles supported on the dye compound for solar cells of Claim 5.

10. A dye-sensitized solar cell comprising the dye-sensitized photoelectric converter of Claim 9.
